# EUROPEAN PATENT APPLICATION

(11) **EP 4 496 098 A1**
(43) Date of publication of application: **22.01.2025**
(21) Application number: 23770375.6
(22) Date of filing: 28.02.2023
(51) Int. Cl.: H01M 50/298, H01M 50/213, H01M 50/284, H05K 7/00

(54) **POWER SUPPLY DEVICE AND LEAD HOLDING STRUCTURE**

(30) Priority: 18.03.2022 JP 2022044335
(71) Applicant: Panasonic Energy Co., Ltd., Osaka 570-8511 (JP)
(72) Inventor: MAEDA, Yusuke, Kadoma-shi, Osaka 571-0057 (JP); YANASE, Dai, Kadoma-shi, Osaka 571-0057 (JP); SHIMIZU, Takashi, Kadoma-shi, Osaka 571-0057 (JP); TAKEUCHI, Motoji, Kadoma-shi, Osaka 571-0057 (JP)
(74) Representative: Novagraaf International SA
(86) International application number: PCT/JP2023/007205
(87) International publication number: WO 2023/176417

(57) **Abstract**

A power supply device includes a battery cell, a circuit board including a board-side connector, a lead wire connected to the board-side connector, an open case accommodating the battery cell, the lead wire, and the circuit board therein, a lid case closing an opening surface of the open case, and a pull-out blocker disposed on the lead wire. The circuit board has a first main surface, a second main surface opposite to the first main surface, and a side surface connected to the and second main surfaces. The side surface has a cut-out therein. The lead wire extends from a first tip end to a second tip end through the cut-out of the circuit board. The first tip end is connected to the board-side connector. The pull-out blocker is disposed at an intermediate position of the lead wire between the first and second tip ends. The pull-out blocker protrudes from the lead wire to be prevented from passing through the cut-out. The pull-out blocker is configured to prevent a portion of the lead wire extending from the first tip end to the cut-out of the circuit board from being greater than or equal to a predetermined length.

## Description

### TECHNICAL FIELD

The present disclosure relates to a power supply device and a lead holding structure.

### BACKGROUND ART

Power supply devices including battery cells connected in series or parallel to one another are used as power sources for portable electric appliances, such as electric cleaners and electric power tools, or in stationary-type electricity storage applications, such as backup power sources for servers or power supply devices for home use, office use, and factory use, or further drive power sources for power assisted bicycles, or drive power sources for vehicles, such as electric scooters, electric carts, hybrid electric vehicles, and battery electric vehicles (for example, PTL 1).

In such a power supply device, a battery block including battery cells and a circuit board are accommodated in a housing. The housing has a separate structure in which an open case with an opening at its top is closed by a lid case. A lead wire is pulled out from an electric system, such as the battery block.

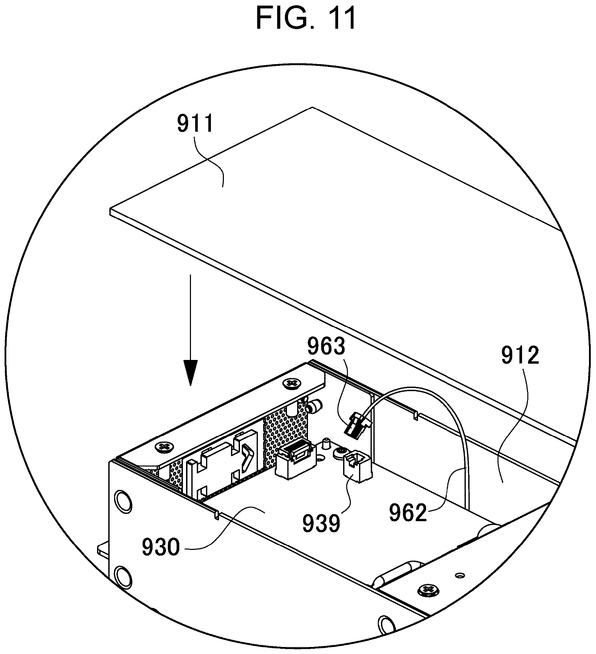

FIG. 11 is an exploded perspective view of a power supply device according to a comparative example for illustrating lead wire 962 inserted into board-side connector 939. Lead wire 962 is configured to be inserted into board-side connector 939 provided on circuit board 930 while being pulled out from a side surface of circuit board 930. Lid case 911 closes open case 912.

### CITATION LIST

### Patent Literature

PTL 1: Japanese Patent Unexamined Publication No. H10-64345

### SUMMARY

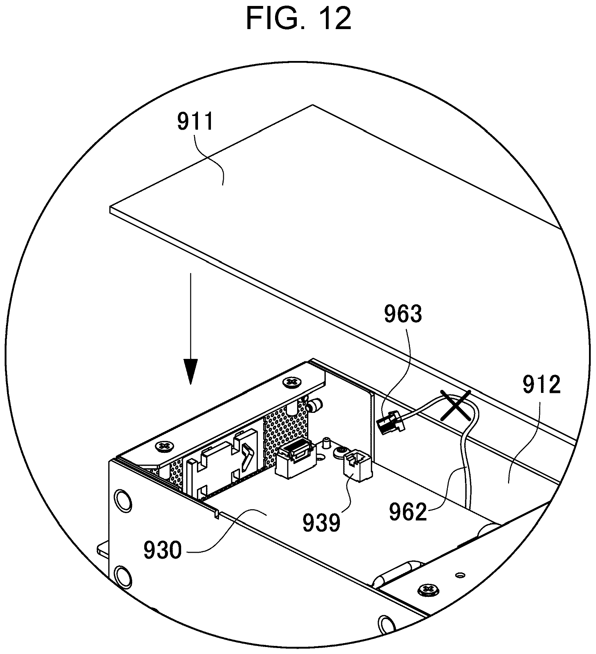

FIG. 12 is an exploded perspective view of the power supply device shown in FIG. 11 for illustrating the lead wire pinched when closing the lid. When lid case 911 closes, lead wire 962 may be often pinched with lid case 911. The length of lead wire 962 is designed to be sufficiently long with some extra margin, taking into consideration the ease of work when connecting lead-side connector 963 of lead wire 962 to board-side connector 939. Consequently, lead wire 962 with an excess length is likely to wobble easily, increasing the risk of causing lead wire 962 to be placed on the edge of open case 912 and to be pinched when lid case 911 closes.

As a countermeasure for this problem, the lead may be tied wire with a cable tie and secure the lead wire inside the case to prevent unintended wobbling of the lead wire. However, this structure requires the space for placing the cable tie, and necessitates the work of screw-fitting for securing the cable tie onto the case, increasing man-hours.

On the other hand, when the length of lead wire short so as to avoid pinching of the lead wire, the amount of stroke of the board-side connector inserted into the circuit board is reduced, hardly performing the work.

Thus, ensuring the workability in connecting the board-side connector of the lead wire and avoiding pinching of the lead wire are conflicting problems in relation to the length of the lead wire, and it has been difficult to solve both problems.

A power supply device according to an aspect of the present disclosure includes a battery cell, a circuit board including a board-side connector, a lead wire connected to the board-side connector, an open case accommodating the battery cell, the lead wire, and the circuit board therein, a lid case closing an opening surface of the open case, and a pull-out blocker disposed at the lead wire. The circuit board has a first main surface including the board-side connector, a second main surface opposite to the first main surface, and a side surface connected to the first main surface and the second main surface. The side surface of the circuit board has a cut-out therein forming openings in the first main surface and the second main surface. The lead wire has a first tip end and a second tip end, and extends from the first tip end to the second tip end through the openings of the cut-out in the side surface of the circuit board. The first tip end is connected to the board-side connector. The first main surface of the circuit board faces the opening surface of the open case. The pull-out blocker is disposed at an intermediate position of the lead wire between the first tip end and the second tip end of the lead wire. The pull-out blocker protrudes from the lead wire to be prevented from passing through the cut-out. The pull-out blocker is configured to prevent a portion of the lead wire extending from the first tip end to the cut-out of the circuit board from having a length greater than or equal to a predetermined length.

A lead holding structure in accordance with another aspect of the present disclosure includes a circuit board including a board-side connector, a lead wire connected to the board-side connector, a lid case closing an opening surface of an open case, and a pull-out blocker disposed at the lead wire. The circuit board has a first main surface including the board-side connector, a second main surface opposite to the first main surface, and a side surface connected to the first main surface and the second main surface. The side surface of the circuit board has a cut-out therein forming openings in the first main surface and the second main surface. The lead wire has a first tip end and a second tip end, and extends from the first tip end to the second tip end through the openings of the cut-out in the side surface of the circuit board. The first main surface of the circuit board faces the opening surface of the housing. The pull-out blocker is disposed at an intermediate position of the lead wire between the first tip end and the second tip end of the lead wire. The pull-out blocker protrudes from the lead wire to be prevented from passing through the cut-out. The pull-out blocker is configured to prevent a portion of the lead wire extending from the first tip end to the cut-out of the circuit board from having a length greater than or equal to a predetermined length.

The power supply device and the lead holding structure according to aspects of the present invention controls the length and position of an excess portion of the lead wire by defining the position of the lead wire in a direction away from the main surface of the circuit board with the pull-out blocker while restricting the position of the lead wire in a direction parallel to the main surface with the cut-out.

### BRIEF DESCRIPTION OF THE DRAWINGS

FIG. 1 is a perspective view of a power supply device according to an exemplary embodiment.
FIG. 2 is an exploded perspective view of the power supply device shown in FIG. 1 with a lid case removed.
FIG. 3 is an exploded perspective view of the power supply device shown in FIG. 2 for illustrating that an inner assembly thereof is removed from an open case.
FIG. 4 is an enlarged perspective view of the power supply device shown in FIG. 3 for illustrating an output unit removed.
FIG. 5 is an enlarged perspective view of the output unit shown in FIG. 4 viewed from an obliquely downward.
FIG. 6 is an exploded perspective view of the output unit shown in FIG. 4 with a circuit board removed.
FIG. 7 is a cross-sectional perspective view of the power supply device along line VII-VII shown in FIG. 1.
FIG. 8 is an enlarged plan view of a cut-out in a circuit board of the power supply device.
FIG. 9 is a side view illustrating a lead wire shown in FIG. 4 connected to a board-side connector.
FIG. 10 is an enlarged view of a pull-out blocker according to a modified example.
FIG. 11 is an exploded perspective view of a power supply device according to a comparative example for illustrating a lead wire inserted into a board-side connector.
FIG. 12 is an exploded perspective view of the power supply device shown in FIG. 11 for illustrating the lead wire pinched when the lid closes.

### DESCRIPTION OF EMBODIMENT

Aspects of the present disclosure may be regarded as the following configurations and features.

In a power supply device according to another aspect of the present disclosure, in an above-described aspect, the cut-out includes a neck portion with an opening width locally decreasing.

The opening width of the neck portion is equal to or less than a diameter of a cross section of the lead wire.

In a power supply device according to still another aspect of the present disclosure, in any one of the foregoing aspects, the cut-out further includes a circular retaining portion larger than the diameter of the cross section of the lead wire, and a wider portion communicating with the circular retaining portion via the neck portion, the wider portion flaring to an outside of the circuit board. This configuration allows the lead wire to be guided from the wider portion into the circular retaining portion easily, and on the other hand, avoids disengagement of the lead wire that is retained by the circular retaining portion beyond the neck portion from the cut-out due to the neck portion.

In a power supply device according to still another aspect of the present disclosure, in any one of the foregoing aspects, the circuit board is made of a material having flexibility. This configuration allows the lead wire to be press-fitted into the cut-out easily.

In a power supply device according to still another aspect of the present disclosure, in any one of the foregoing aspects, the pull-out blocker has a tab shape attached at a position that is at a middle of the lead wire and that is at a limit length at which pull-out is permitted. The tab shape protrudes from a side surface of the lead wire. In this configuration, even when it is attempted to pull out the lead wire from the cut-out of the circuit board, the tab shape protruding from the lead wire contacts the second main surface of the circuit board when the lead wire is pulled out longer than or equal to a predetermined length, thereby preventing the lead wire from being pulled out further. Thus, the length of the pulled-out portion of the lead wire is prevented from being longer than necessary.

In a power supply device according to still another aspect of the present disclosure, in any one of the foregoing aspects, the pull-out blocker is a stopper with a wire diameter of the lead wire locally increasing at a middle of the lead wire which a limit length at which pull-out is permitted. In this configuration, even when it is attempted to pull out the lead wire from the cut-out of the circuit board, the stopper with the large wire diameter of the lead wire contacts the second main surface of the circuit board when the lead wire is pulled out longer than or equal to a predetermined length, thereby preventing the lead wire from being pulled out further. Therefore, the length of the pulled-out portion of the lead wire is prevented from being longer than necessary.

In a power supply device according to still another aspect of the present disclosure, in any one of the foregoing aspects, the stopper is a tape wound around a middle of the lead wire. This configuration provides the stopper with the wire diameter of the lead wire locally increasing at a desired position on the lead wire.

Exemplary embodiments of the present disclosure will be described below with reference to the drawings. The following embodiments are merely examples for embodying the technical ideas of the present invention, and the present invention is not limited to the following exemplary embodiments. In addition, the present description is in no way provided for limiting the members shown in the claims to the members illustrated in the exemplary embodiments. Moreover, the dimensions, materials, shapes, relative arrangements, and the like of parts and elements described in the following exemplary embodiments are merely illustrative examples, and should not be construed to limit the scope of the invention, unless specifically stated otherwise. Furthermore, the sizes of some elements, their positional relationships, and so forth shown in the drawings may be exaggerated for clarity in illustration. In the following description, like names and symbols refer to same or similar elements, and detailed description thereof will not be given as appropriate. Furthermore, each of the elements that constitute the present disclosure may be embodied by an embodiment in which one member serves as a plurality of elements so that the plurality of elements are composed of the same member, or conversely, may be achieved in such an embodiment in which the function of one member is shared among a plurality of members.

The power supply device of the present disclosure may be utilized as a power source for portable electric appliances, such as electric cleaners and electric power tools, or as a power supply device in stationary-type electricity storage applications, such as backup power sources for servers, home use, office use, and factory use power supply devices, or further, drive power sources for power assisted bicycles, or drive power sources for vehicles, such as electric scooters, electric carts, hybrid electric vehicles, and battery electric vehicles. Hereinafter, a power supply device used as a backup power source for servers or the like is described as one exemplary embodiment of the present disclosure.

### Exemplary Embodiment

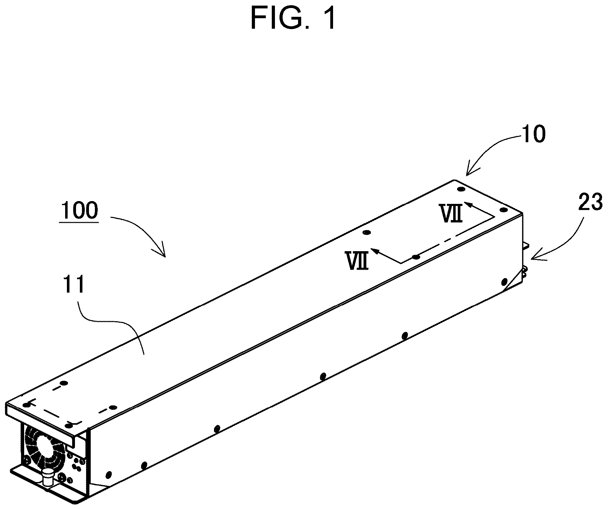

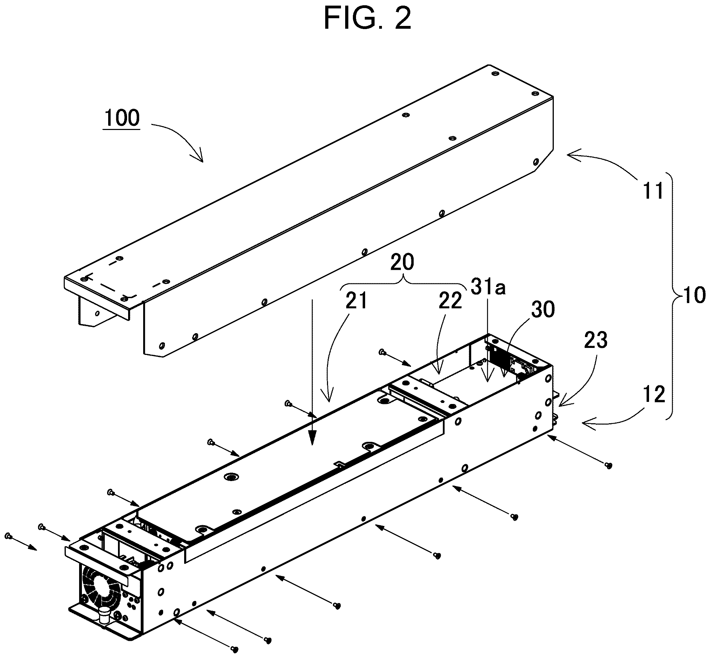

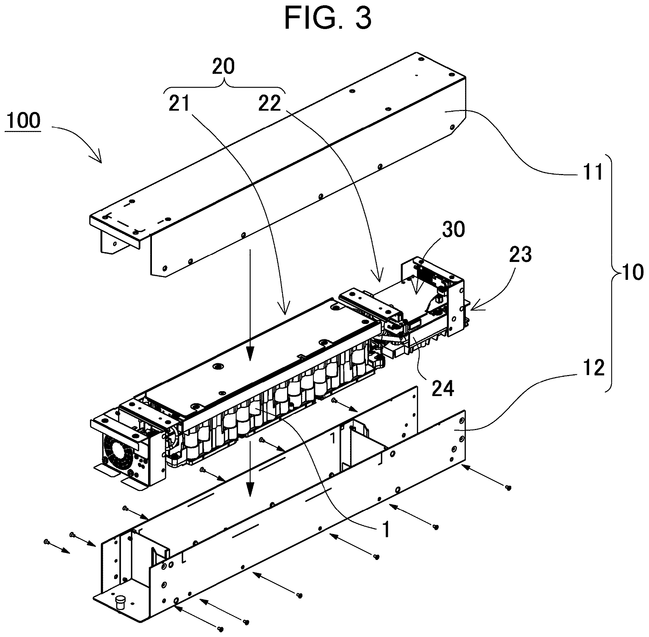

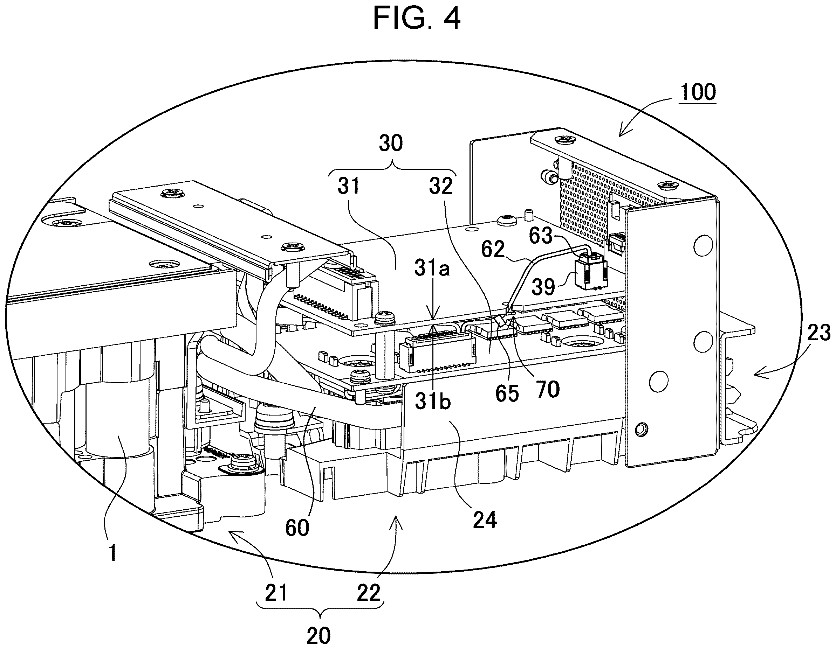

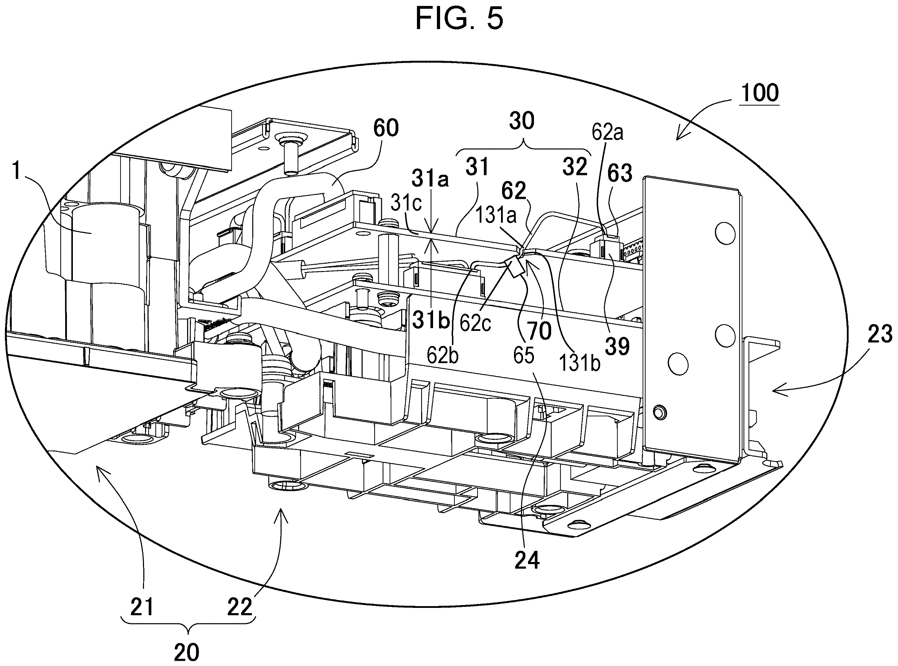

Power supply device 100 according to an exemplary embodiment of the present disclosure is shown in FIGS. 1-5. FIG. 1 is a perspective view of power supply device 100 according to the embodiment. FIG. 2 is an exploded perspective view of power supply device 100 shown in FIG. 1 with lid case 11 removed. FIG. 3 is an exploded perspective of inner assembly 20 shown in FIG. 2 removed from open case 12. FIG. 4 is an enlarged perspective view of output unit 22 shown in FIG. 3. FIG. 5 is an enlarged perspective view of output unit 22 shown in FIG. 4 viewed from an obliquely downward. Power supply device 100 shown in these drawings includes housing 10 and inner assembly 20. Housing 10 accommodates contents therein. Housing 10 shown in FIG. 1 has a box shape and has a storage space accommodating inner assembly 20 therein. In the example shown in FIG. 2, housing 10 is divided into two pieces, lid case 11 and open case 12. Open case 12 has an opening surface. Lid case 11 closes the opening surface of open case 12. Housing 10 is made of metal, resin, or the like.

Inner assembly 20 includes battery block 21 including one or more battery cells 1, and output unit 22 including external output terminal 23. In the example of FIG. 3, battery block 21 includes cylindrical secondary battery cells in a battery holder such that the battery cells are aligned vertically. Battery cells 1 are connected in parallel and series to one another.

### Output Unit 22

As illustrated in FIGS. 4 and 5, output unit 22 includes unit case 24, circuit board 30, external output terminal 23, and guide piece 26. Unit case 24 constitutes a part of housing 10 that accommodates the content therein, and retains circuit board 30 and external output terminal 23. Unit case 24 is made of an insulative material, such as resin.

### Circuit Board 30

Electronic circuits are mounted on circuit board 30. The electronic circuits may be a voltage detection circuit that detects the total potential of or the potential at the middle of a battery assembly in which battery cells 1 are connected in series or parallel to one another, a control circuit that controls charging and discharging, a safety circuit, and the like. Circuit board 30 has a rectangular shape.

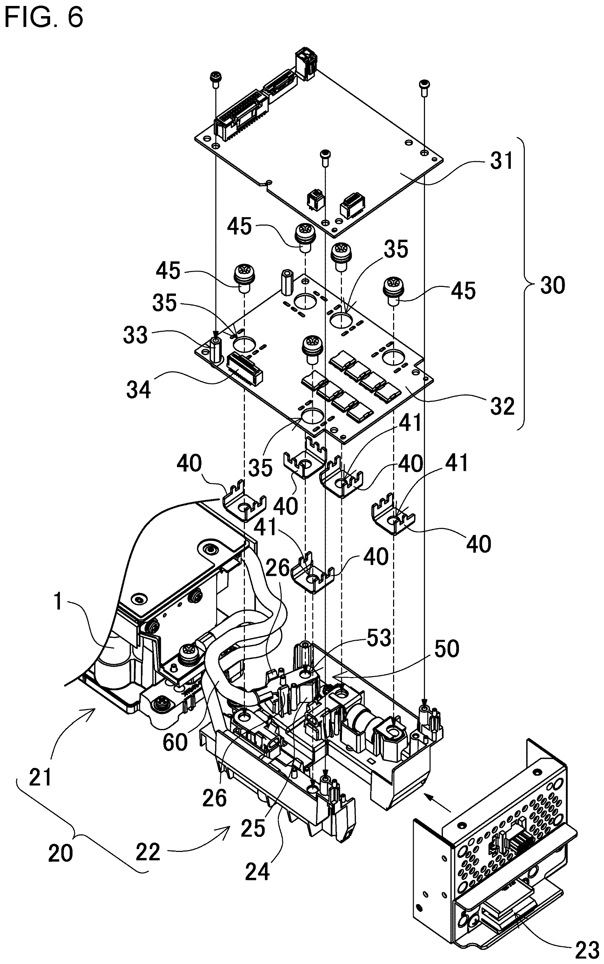

In the example of FIG. 6, circuit board 30 includes two boards, first board 31 and second board 32. First board 31 and second board 32 are coupled with a space provided by spacer 33 in between. First board 31 and second board 32 are electrically connected to each other via board connector 34. In addition, square C-shaped conductive spacers 40 are fixed on a lower surface of second board 32. First board 31 and second board 32 may preferably be made of a material having flexibility, for example, a resin such as glass epoxy.

### Square U-shaped Conductive Spacer 40

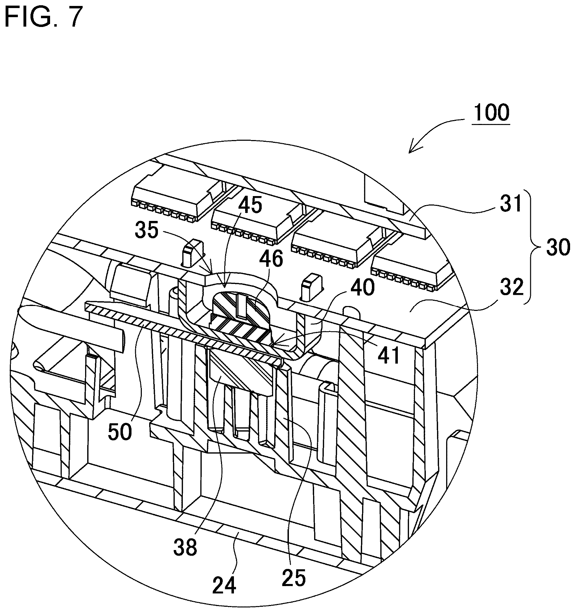

Each of square C-shaped conductive spacers 40 has a square U cross-sectional shape. As illustrated in the cross-sectional view of FIG. 7, square C-shaped conductive spacers 40 are screw-fitted and electrically connected to circular terminals 50 with screws 45. Thus, each square U-shaped conductive spacer 40 has spacer threaded hole 41 for being screw-fitted with screw 45 in an upper surface of the square U shape.

The example of FIG. 6 has a configuration in which square U-shaped conductive spacers 40 are screw-fitted to unit case 24 with screws 45 from the reverse surface side (the upper surface side shown in FIG. 6) of second board 32. For this reason, large board through-holes 35 through which screw head 46 of screw 45 can inserted are formed in the reverse surface side of the locations of second board 32 at which square U-shaped conductive spacers 40 are provided. As a result, second board 32 on which square U-shaped conductive spacers 40 have been previously soldered is placed on unit case 24 on which square nut 38 and circular terminal 50 are previously set, and screw 45 is fastened together with circular terminal 50 from the reverse side of square U-shaped conductive spacer 40 through board through-hole 35. This configuration allows square U-shaped conductive spacers 40 which have been soldered on the obverse surface side of second board 32 to be screw-fitted to circular terminals 50 even from the reverse surface side of second board 32. Particularly in the configuration of FIG. 7, circular terminal 50 and second board 32 are fixed to unit case 24 simultaneously because of the configuration in which circular terminal 50 is fastened together with square U-shaped conductive spacers 40. As illustrated in FIG. 6, circular terminal 50 is screw-fitted from the reverse surface side of second board 32. This configuration causes circular terminal 50 to be hidden by second board 32 and prevents circular terminal 50 from being seen. Therefore, even if circular terminal 50 is misaligned, circular terminal 50 is not recognized visually. Where circular terminal 50 needs to be held reliably in a positioning posture, the above-described configuration allows terminal threaded hole 53 of circular terminal 50 to be continuously centered with square nut 38 retained on nut holding wall 25, performing the assembling work smoothly. While second board 32 is screw-fitted to unit case 24, first board 31 is secured to the reverse surface side of second board 32.

External output terminal 23 is a terminal configured to output to outside the output voltage of battery cells 1 that are connected in series or parallel to one another. The total output of battery block 21 is connected to external output terminal 23 via harness 60.

### Harness 60

As illustrated in FIG. 6, circular terminals 50 and harness 60 are disposed at the reverse side of circuit board 30. Harness 60 is connected to the output of battery block 21. Circular terminals 50 are electrically connected to circuit board 30.

### First Board 31

First board 31 has first main surface 31a, second main surface 31b opposite of first main surface 31a, and side surface 31c connected to first main surface 31a and second main surface 31b. In FIGS. 4 and 5, the upper surface of first board 31 is first main surface 31a, and the lower surface of first board 31 is second main surface 31b. First Board 31 includes board-side connector 39 on first main surface 31a. Board-side connector 39 is connected to the other end of lead wire 62. As illustrated in FIG. 2, first board 31 is accommodated in open case 12 such that first main surface 31a faces the opening surface of open case 12.

### Lead Wire 62

First board 31 and second board 32 are connected with lead wire 62, as illustrated in FIG. 5. Lead wire 62 is drawn out from second main surface 31b of first board 31 to first main surface 31a via side surface 31c of first board 31. The tip end of lead wire 62 is connected to board-side connector 39. For this reason, lead-side connector 63 is provided at the tip end of lead wire 62. Lead wire 62 is made of material having flexibility.

### Cut-Out 70

Circuit board 30 has cut-out 70 formed in a portion of an edge thereof, as illustrated in FIGS. 4 and 5. Lead wire 62 is drawn out from second main surface 31b of circuit board 30 through cut-out 70 to first main surface 31a. Cut-out 70 provided in side surface 31c of circuit board 30 (board 31) constitutes opening 131a in first main surface 31a of board 31 and opening 131b in second main surface 31b. Lead wire 62 extends from first tip end 62a, connected to board-side connector 39 to second tip end 62b through openings 131a and 131b of cut-out 70 in side surface 31c of board 31. Lead wire 62 is provided with pull-out blocker 65 disposed at intermediate position 62c on lead wire 62 between first tip end 62a and second tip end 62b. Pull-out blocker 65 protrudes to be prevented from passing through cut-out 70. Lead wire 62 is configured not to be pulled out greater than or equal to a predetermined length to first main surface 31a by pull-out blocker 65. In other words, lead wire 62 is configured to have pull-out blocker 65 prevent portion 162 of lead wire 62 extending from first tip end 62a to cut-out 70 of board 31 from having a length exceeding a predetermined length. Such a configuration avoids the pinching of lead wire 62 when lid case 11 closes the opening of open case 12.

As illustrated in FIG. 11, in the configuration in which lead wire 962 is connected to board-side connector 939 of circuit board 930, lead wire 962 is designed to be somewhat longer to provide a sufficient stroke in inserting lead-side connector 963 of lead wire 962 into board-side connector 939 and to make the work easier. Consequently, lead wire 962 is provided with a degree of freedom so that lead wire 962 is movable easily within open case 912. For this reason, lead wire 962 may be pinched erroneously as illustrated in FIG. 12 when lid case 911 closes.

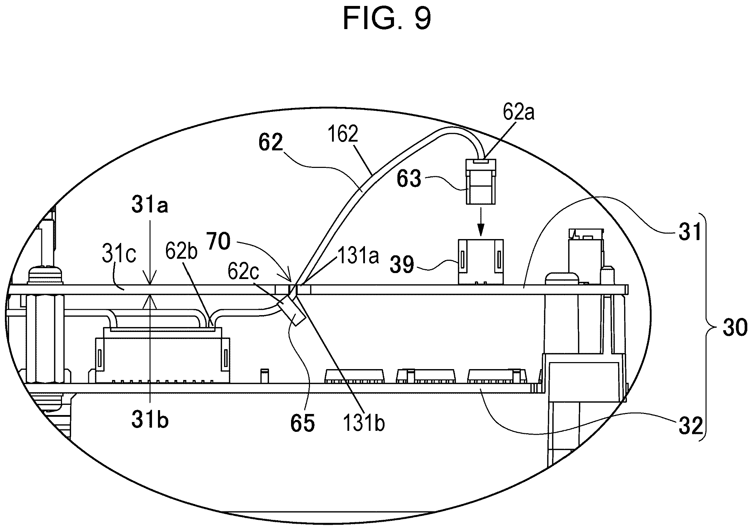

In view of the problem, power supply device 100 according to the present embodiment has a lead holding structure that restrains lead wire 62 so as not to move freely. Specifically, as illustrated in FIGS. 4, 5, and 8, cut-out 70 is formed in a portion of the edge of circuit board 30 to restrict the position of lead wire 62 in a direction parallel to main surfaces 31a and 31b of board 31. Furthermore, the position of lead wire 62 that is in a direction away from main surface 31a of board 31 is determined by pull-out blocker 65 provided on lead wire 62. Specifically, as illustrated in FIG. 9, pull-out blocker 65 is provided at a position that is at a middle of lead wire 62 and that results in a length that ensures a minimum stroke necessary to easily insert and remove lead-side connector 63 at the tip end of lead wire 62 into and from board-side connector 39. This configuration controls the length and position of an excess portion of lead wire 62. That is, while maintaining the workability so as not to prevent the work of inserting lead-side connector 63, provided at the tip end of lead wire 62, into board-side connector 39, by providing a sufficient length of the excess portion of lead wire 62, lead wire 62 is restrained by pull-out blocker 65 so as not to be pulled out beyond a predetermined length. This configuration avoids pinching of lead wire 62 by lid case 11 when lid case 11 closes the opening of open case 12. Pull-out blocker 65 is disposed at a middle of lead wire 62 from cut-out 70 of board 31 to second tip end 62b of lead wire 62. Pull-out blocker 65 is configured to contacts second main surface 31b of board 31 when the length of portion 162 of lead wire 62 from cut-out 70 of board 31 to first tip end 62a is a predetermined length.

### Neck Portion 71

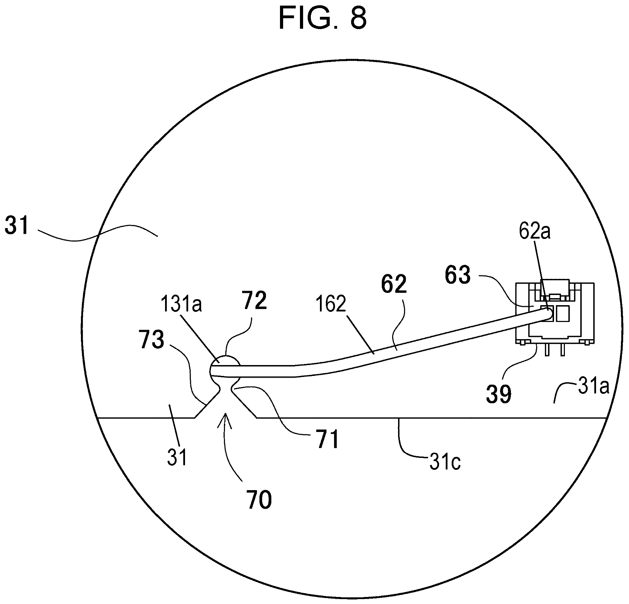

As illustrated in the enlarged view of FIG. 8, cut-out 70 preferably includes neck portion 71 with an opening width locally decreasing. The opening width of neck portion 71 is designed so as to be equal to or less than the diameter of the cross section of lead wire 62. Cut-out 70 further includes circular retaining portion 72 with a circular shape connected continuously to neck portion 71. This configuration allows lead wire 62 to be hardly taken out of cut-out 70 after lead wire 62 is press-fitted into cut-out 70 and pushed into circular retaining portion 72 beyond neck portion 71. Particular in the case that lead wire 62 is made of material having flexibility or first board 31 is made of a material having flexibility, lead wire 62 may be press-fitted easily beyond neck portion 71.

In the example of FIG. 8, cut-out 70 includes circular retaining portion 72 larger than the diameter of the cross section of lead wire 62, and wider portion 73 that communicates with circular retaining portion 72 via neck portion 71 and flares to an outside of the circuit board. This configuration allows lead wire 62 to be guided from wider portion 73 into circular retaining portion 72 easily, and on the other hand, neck portion 71 prevents lead wire 62 retained by circular retaining portion 72 beyond neck portion 71 from being taken out from cut-out 70.

### Pull-out Blocker 65

Pull-out blocker 65 may have a configuration preventing lead wire 62 from being pulled out greater than or equal to a predetermined length, as appropriate. For example, in the example shown in FIG. 9, pull-out blocker 65 has a tab shape attached at a limit length position at which pull-out is permitted. This tab shape protrudes from the side surface of lead wire 62. For example, the tab shape protruding in one direction from the outer circumference of lead wire 62 is formed by affixing a rectangular-shaped sticker to lead wire 62 so as to pinch lead wire 62. When lead wire 62 including the tab shape is pulled out toward first main surface 31a, the tab shape contacts second main surface 31b of first board 31 when lead wire 62 is pulled out to some degree, thereby restricting lead wire 62 from being pulled out further. when necessary, such as when it is desired to pull out lead wire 62 particularly, lead wire 62 may be pulled out by bringing the direction in which the tab shape protrudes in agreement with the neck portion 71 of cut-out 70.

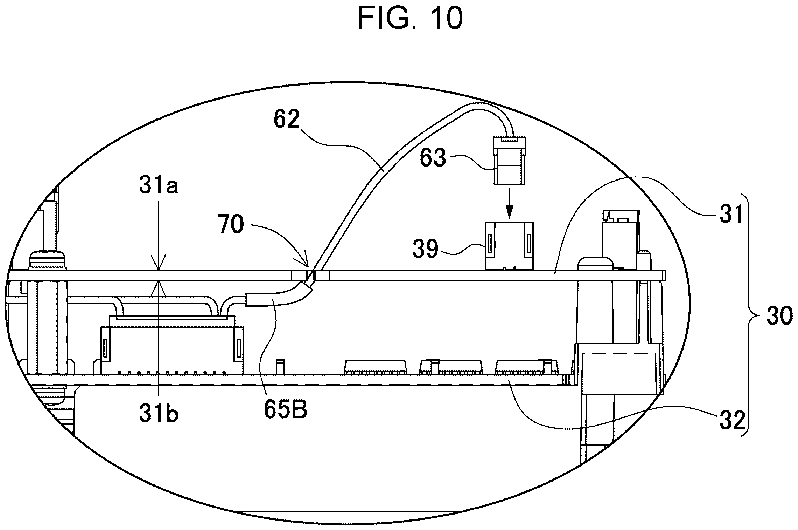

As another example of pull-out blocker 65, a power supply device according to a modified example of FIG. 10 has a configuration of stopper 65B in which the wire diameter of lead wire 62 locally increases. In this configuration, even when lead wire 62 is pulled out from cut-out 70 of circuit board 30, stopper 65B having a wire diameter of lead wire 62 locally increasing contacts second main surface 31b of circuit board 30 when lead wire 62 is pulled out greater than or equal to a predetermined length, thereby preventing lead wire 62 from being pulled out further. Therefore, it is possible to avoid such an incident that the length of a portion of lead wire 62 that is pulled out becomes longer than is necessary, causing pinching or the like. Moreover, this configuration allows pull-out blocker 65 to function irrespective of the rotational direction of lead wire 62. Stopper 65B may be implemented by a tube made of rubber, for example.

Alternatively, as another pull-out blocker 65, a tape may be wrapped around a middle of lead wire 62 to locally increase the wire diameter of lead wire 62 so as not to pass through circular retaining portion 72 of cut-out 70. This configuration easily form stopper 65B with the wire diameter of lead wire 62 locally increasing at a desired position of lead wire 62.

### INDUSTRIAL APPLICABILITY

A power supply device and a lead holding structure according to the present disclosure may be suitably used for power sources of portable type electrical appliances, such as electric cleaners and electric power tools. The power supply device and the lead holding structure according to the present disclosure may also be appropriately used for applications such as power supply devices for mobile bodies, such as power assisted bicycles and electric carts, and applications in which a lead wire is pulled out to make electrical connection in various types of electrical appliance.

### REFERENCE MARKS IN DRAWINGS

- 100: power supply device
- 1: battery cell
- 10: housing
- 11: lid case
- 12: open case
- 20: inner assembly
- 21: battery block
- 22: output unit
- 23: external output terminal
- 24: unit case
- 25: nut holding wall
- 26: guide piece
- 30: circuit board
- 31: first board
- 31a: first main surface
- 32b: second main surface
- 32: second board
- 33: spacer
- 34: board connector
- 35: board through-hole
- 38: square nut
- 39: board-side connector
- 40: square U-shaped conductive spacer
- 41: spacer threaded hole
- 45: screw
- 46: screw head
- 50: circular terminal
- 53: terminal threaded hole
- 60: harness
- 62: lead wire
- 63: lead-side connector
- 65: pull-out blocker
- 65B: stopper
- 70: cut-out
- 71: neck portion
- 72: circular retaining portion
- 73: wider portion
- 911: lid case
- 912: open case
- 930: circuit board
- 939: board-side connector
- 962: lead wire
- 963: lead-side connector

## Claims

1. A power supply device comprising:
a battery cell;
a circuit board having a first main surface, a second main surface opposite to the first main surface, and a side surface connected to the first main surface and the second main surface, the circuit board including a board-side connector on the first main surface, the side surface having a cut-out therein forming openings in the first main surface and the second main surface;
a lead wire having a first tip end and a second tip end, and extending from the first tip end to the second tip end through the openings of the cut-out in the side surface of the circuit board, the first tip end being connected to the board-side connector;
an open case accommodating the battery cell, the lead wire, and the circuit board therein, the open case having an opening surface that the first main surface of the circuit board faces;
a lid case closing the opening surface of the open case; and
a pull-out blocker disposed at an intermediate position of the lead wire between the first tip end and the second tip end of the lead wire, wherein:
the pull-out blocker protrudes from the lead wire to be prevented from passing through the cut-out; and
the pull-out blocker is configured to prevent a portion of the lead wire extending from the first tip end to the cut-out of the circuit board from having a length greater than or equal to a predetermined length.

2. The power supply device according to claim 1, wherein:
the cut-out includes a neck portion having an opening width locally decreasing; and
the opening width of the neck portion is equal to or less than a diameter of a cross section of the lead wire.

3. The power supply device according to claim 2, wherein the cut-out further includes:
a circular retaining portion larger than the diameter of the cross section of the lead wire; and
a wider portion communicating with the circular retaining portion via the neck portion, the wider portion flaring to an outside of the circuit board.

4. The power supply device according to any one of claims 1 to 3, wherein the circuit board is made of a material having flexibility.

5. The power supply device according to any one of claims 1 to 4, wherein:
the pull-out blocker is in a tab shape; and
the tab shape protrudes from a side surface of the lead wire.

6. The power supply device according to any one of claims 1 to 4, wherein the pull-out blocker is a stopper at which a diameter of the lead wire locally increases.

7. The power supply device according to claim 6, wherein the pull-out blocker is made of a tape wound on a middle of the lead wire.

8. The power supply device according to any one of claims 1 to 7, wherein the pull-out blocker is disposed between the second tip end and the cut-out of the circuit board.

9. The power supply device according to any one of claims 1 to 8, wherein the pull-out blocker is configured to contact the second main surface of the circuit board when the length of the portion of the lead wire from the cut-out of the circuit board to the first tip end of the lead wire is the predetermined length.

10. A lead holding structure comprising:
a circuit board having a first main surface, a second main surface opposite to the first main surface, and a side surface connected to the first main surface and the second main surface, the circuit board including a board-side connector on the first main surface, the side surface having a cut-out therein forming openings in the first main surface and the second main surface;
a lead wire having a first tip end and a second tip end, and extending from the first tip end to the second tip end through the openings of the cut-out in the side surface of the circuit board, the first tip end being connected to the board-side connector;
a housing accommodating the lead wire and the circuit board therein, the housing having an opening surface that the first main surface of the circuit board faces; and
a pull-out blocker disposed at an intermediate position of the lead wire between the first tip end and the second tip end of the lead wire, wherein:
the pull-out blocker protrudes from the lead wire to be prevented from passing through the cut-out; and
the pull-out blocker is configured to prevent a portion of the lead wire extending from the first tip end to the cut-out of the circuit board from having a length greater than or equal to a predetermined length.
